# FASCICULE DE BREVET EUROPEEN

(11) **EP 2 171 851 B1**
(45) Date de publication et mention de la délivrance du brevet: **22.12.2010**
(21) Numéro de dépôt: 08826630.9
(22) Date de dépôt: 11.07.2008
(51) Int. Cl.: H03K 19/08, H03K 19/0944, H03K 19/173

(54) **CELLULE LOGIQUE RECONFIGURABLE A BASE DE TRANSISTORS MOSFET DOUBLE GRILLE**
REKONFIGURIERBARE LOGIKZELLE AUS DOPPELGATE-MOSFET-TRANSISTOREN
RECONFIGURABLE LOGIC CELL MADE UP OF DOUBLE-GATE MOSFET TRANSISTORS

(30) Priorité: 13.07.2007 FR 0756487
(43) Date de publication de la demande: 07.04.2010
(73) Titulaire: Ecole Centrale de Lyon, 69134 Ecully Cedex (FR); Centre National de la Recherche Scientifique (CNRS), 75794 Paris Cedex 16 (FR)
(72) Inventeur: O'CONNOR, Ian D., F-01480 Jassans-Riottier (FR); HASSOUNE, Ilham, 92160 Antony (FR)
(74) Mandataire: Thibault, Jean-Marc
(86) Numéro de dépôt international: PCT/FR2008/051309
(87) Numéro de publication internationale: WO 2009/013422

(56) Documents cités:
- EP-A- 0 264 334
- US-A- 5 777 491
- US-A1- 2004 041 588

## Description

### Arrière-plan de l'invention

La présente invention se rapporte au domaine général des cellules logiques reconfigurables comprenant une pluralité d'entrées et aptes à réaliser un certain nombre de fonctions logiques permettant de traiter les signaux logiques fournis sur leurs entrées.

Plus précisément, l'invention propose des cellules logiques reconfigurables à coûts de production réduit.

Le coût de production des circuits intégrés est essentiellement dû au coût de la conception des masques utiles à la lithographie et au coût des équipements automatiques utilisés pour la production des circuits intégrés, notamment les appareils de photolithographie.

Ces coûts de production augmentent régulièrement avec les tendances actuelles à la miniaturisation et à la complexité des architectures. Aussi, des dispositifs de plus en plus sophistiqués sont nécessaires afin de répondre à un certain nombre de problèmes engendrés par la miniaturisation qui engendre des problèmes de courants de fuite et de fiabilité de comportement. Tout cela complexifie considérablement la conception des masques.

Les circuits dédiés, par exemple les circuits ASIC (« Application Specific Integrated Circuit » en anglais), qui existent depuis les années 1970, présentent une densité d'intégration très élevée et sont conçus pour une application spécifique. Leur conception est longue et coûteuse et la moindre erreur de conception nécessite une nouvelle refonte du circuit.

Afin de garantir une plus grande souplesse, des circuits programmables ont été développés. Ils offrent une bonne tolérance aux fautes et permettent des réutilisations pour différentes applications. En particulier, les masques peuvent être réutilisés dans divers contextes. Différents types d'architecture existent pour de tels circuits, par exemple les circuits FPGA pour « Field Programmable Gate Array » en anglais, CPLD pour « Complex Programmable Logic Device » en anglais, ou encore PLA pour « Programmable Logic Array » en anglais. Ils sont apparus dans les années 1980 (EP-A-0 264 334, FAIRCHILD SEMICONDUCTOR [US], 20 avril 1988).

Leur souplesse et leur conception moins complexes que celles des circuits dédiés, comme les ASICs, ont rendu ces circuits populaires dans le milieu industriel. Ils sont souvent connus sous le nom de « fonctions universelles ». De tels circuits programmables utilisent la logique CMOS statique complémentaire. Avec ces circuits, il est possible de connecter entre eux des éléments de base que sont les fonctions logiques de base.

Il est ainsi possible de réaliser n'importe quelle fonction logique souhaitée par l'utilisateur mais ces circuits programmables restent néanmoins largement désavantagés en comparaison avec les ASICs en termes de performance et de consommation.

En effet, ces derniers sont généralement optimisés pour fonctionner à grande vitesse et/ou à faible consommation ce qui n'est pas le cas pour les circuits programmables qui utilisent des réseaux d'interconnexion pour connecter les différents éléments de base et sont donc handicapés par les capacités parasites apportées par ces interconnexions entre les éléments de base.

Il existe aujourd'hui d'autres styles logiques pour implémenter des éléments de base et permettre de réaliser des cellules reconfigurables. L'implémentation de telles cellules reconfigurables au lieu de cellules logiques conventionnelles permet d'envisager la réduction des interconnexions et l'accès à une pleine utilisation des ressources pour le calcul.

Cela est bénéfique en termes de performance et de consommation mais aussi en termes de coût puisque la surface de silicium et le nombre de couches métalliques nécessaires pour le routage d'interconnexions sont réduits.

Ces approches permettent la réalisation d'un certain nombre de fonctions logiques et utilisent des dispositifs à effet Hall ou encore des dispositifs CNTFET pour « Carbon Nanotube FET » en anglais, ou encore des composants RTD pour « Resonant Tunneling Diode » en anglais, en combinaison avec un composant HFET pour « Heterostructure FET ».

Cependant, certains de ces procédés de fabrication ne sont pas matures, la technologie CNTFET notamment, et certains sont complexes et donc couteux, les technologies RTD/HFET et CMOS/Effet Hall notamment.

En effet, les composants utilisant l'effet Hall ne sont pas aisément co-intégrables avec la technologie CMOS, ce qui complique la fabrication et la rend couteuse.

Les composants RTD ne sont, eux, pas compatibles avec la technologie CMOS, ce qui implique des connections externes et une complexification du circuit final.

Les composants CNTFET sont difficilement exploitables d'un point de vue industriel puisque cette technologie n'est pas encore suffisamment mature pour conduire à une production industrielle.

Il n'en reste pas moins vrai qu'il existe un grand besoin pour des circuits reconfigurables de conception et d'intégration faciles et peu coûteux qui, grâce à leur possibilité d'être utilisés dans de multiples applications, permettraient de rentabiliser à moyen terme le coût des masques.

### Objet et résumé de l'invention

La présente invention a donc pour but principal de palier de tels inconvénients en proposant un nouveau style de cellules logiques reconfigurables basé sur l'utilisation de dispositifs MOSFET à double grille et permettant une conception à granularité fine des circuits basés sur la logique programmable.

L'invention permet également de réduire, par rapport à la logique CMOS statique conventionnelle, le nombre de transistors nécessaires pour implémenter les mêmes fonctions. Elle permet aussi de réduire le réseau d'interconnexions qui constitue un handicap des circuits programmables basés sur la logique CMOS statique conventionnelle.

L'invention permet donc l'accès à un fonctionnement à haute performance répondant aux besoins actuels en réduction de consommation et en vitesse.

La présente invention propose donc une cellule logique reconfigurable comprenant n entrées, n étant supérieur ou égal à 2, et apte à réaliser au moins quatre fonctions logiques permettant de traiter des signaux logiques fournis sur les n entrées, caractérisée en ce qu'elle comprend, entre la masse et la sortie de la cellule, au moins une première branche comportant n transistors MOSFET de type N à double grille en série et n-1 branches en parallèle de la première branche pourvues chacune d'un transistor MOSFET de type N à double grille, chacune des fonctions logiques correspondant à une configuration donnée de la cellule où un ensemble spécifique de signaux de contrôle est appliqué sur les grilles arrière d'au moins une partie des transistors, chaque signal de contrôle étant apte à mettre le transistor dans un mode de fonctionnement particulier, les n entrées étant connectées chacune sur la grille avant d'un des n transistors de la première branche, n-1 entrées étant aussi appliquées sur la grille avant d'un des n-1 transistors des n-1 branches en parallèle de la première branche.

Sur une telle cellule, la sortie de la cellule correspond donc au point commun aux branches de la cellule le plus éloigné de la masse.

Avec une telle cellule logique reconfigurable, l'utilisation de la polarisation des grilles arrière des transistors permet d'ajuster la tension de seuil de ces transistors de façon à les rendre compatibles avec la fonction désirée.

Chaque fonction logique est donc rendue disponible dans une configuration qui dépend de la polarisation des grilles arrière de certains transistors de la cellule.

Le style logique proposé dans l'invention offre une possibilité de rupture avec le style logique habituellement utilisé pour ce genre d'application et ce, en utilisant uniquement des dispositifs MOSFET double grille. Il est possible de reproduire la fonctionnalité requise de interrupteur en utilisant une structure de circuit à base de transistors MOS à grille unique (US-A-5,777,491, HWANG WEI [US], 7 juillet 1998), mais cela implique l'utilisation de six transistors et des interconnexions les reliant ce qui augmente significativement la consommation, la surface et donc le prix de revient.

Le concept de reconfigurabilité utilisé dans l'invention permet un gain en termes de surface. Il permet en effet de réduire le nombre de cellules logiques nécessaires pour implémenter le même nombre de fonctions logiques en comparaison avec l'implémentation de ces fonctions avec une logique CMOS conventionnelle. De plus, il permet de réduire le réseau d'interconnexions. Cela réduit également les capacités dues au routage dans le réseau d'interconnexions.

La consommation dynamique est donc réduite de façon conséquente et la vitesse est améliorée. On réalise ainsi un compromis entre les performances en termes de vitesse et de consommation et la souplesse d'utilisation.

Selon un premier mode de réalisation de l'invention, n est égal à 2, une première entrée étant connectée aux grilles reliée d'un premier transistor de la première branche, une seconde entrée étant connectée à la grille avant du second transistor de la première branche dont les grilles sont séparées et à la grille avant du transistor de la seconde branche dont les grilles sont également séparées, des signaux de contrôle appliqués sur les grilles arrière du second transistor de la première branche et du transistor de la seconde branche permettant de rendre la cellule reconfigurable apte à réaliser quatre fonctions.

Selon un second mode de réalisation de l'invention, n est égal à 3, tous les transistors étant à grilles séparées, une première entrée étant connectée à la grille avant d'un premier transistor de la première branche, une deuxième entrée étant connectée à la grille avant d'un deuxième transistor de la première branche et à la grille avant du transistor de la deuxième branche, une troisième entrée étant connectée à la grille avant du troisième transistor de la première branche et à la grille avant du transistor de la troisième branche, cinq signaux de contrôle appliqués sur les grilles arrière des cinq transistors permettant de rendre la cellule reconfigurable apte à réaliser onze fonctions.

Selon une caractéristique particulière de l'invention, les signaux de contrôle présentent une tension choisie parmi -Vdd, 0, +Vdd, Vdd étant la tension d'alimentation de la cellule.

Cette caractéristique permet de positionner chaque transistor dans son diagramme de fonctionnement en autorisant une conduction permanente ou une conduction contrôlable avec la tension appliquée sur la grille avant ou encore en bloquant totalement la conduction quelle que soit la polarisation de la grille avant.

Dans un premier type d'implémentation de l'invention, la cellule reconfigurable est implémentée en logique dynamique, les branches de la cellule étant mises en série, entre la masse et une borne d'alimentation, entre un transistor de précharge de type P (Mp) et un transistor d'évaluation de type N (Mn), dont les grilles sont commandées par un signal d'horloge et en ce que les transistors des n-1 branches en parallèle de la première branche sont asymétriques. La logique dynamique a déjà été utilisée avec succès pour réaliser des fonctions logiques fixes. En couplant ce style logique avec la technique de la logique différentielle (US 2004/041588A1, CHOE SWEE YEW [US], 4 mars 2004), il est possible de réduire la consommation et la surface. Cependant, les circuits obtenus par cette méthode ne sont pas reconfigurables.

On entend par « transistor double grille MOSFET symétrique » un transistor MOSFET double grille dans lequel les épaisseurs d'oxyde de grille pour les grilles avant et arrière ou, plus généralement, pour lequel les fonctions de travail sont symétriques et par « transistor double grille MOSFET asymétrique » un transistor MOSFET double grille dans lequel les épaisseurs d'oxyde de grille sont différentes pour les grilles avant et arrière, ou, plus généralement, pour lequel les fonctions de travail sont asymétriques, cela pouvant être obtenu en utilisant deux matériaux différents pour les grilles avant et arrière.

Avantageusement, dans une telle cellule réalisée en logique dynamique, tous les transistors sont asymétriques.

Une telle caractéristique permet une fabrication aisée de la cellule reconfigurable, selon l'invention, puisqu'elle autorise l'utilisation d'un ensemble de transistors, tous fabriqués avec les mêmes caractéristiques.

Selon un autre type d'implémentation, la cellule reconfigurable est implémentée en logique statique, les branches de la cellule étant mise en série entre la masse et une borne d'alimentation avec un réseau complémentaire de transistors placé entre le point commun aux branches de la cellule le plus éloigné de la masse constituant la sortie de la cellule et la borne d'alimentation.

Plus particulièrement, selon ce type d'implémentation, n étant égal à 2, le réseau complémentaire comprend, entre la borne d'alimentation et la sortie de la cellule, un transistor MOSFET de type P des transistors des branches de la cellule en série avec deux transistors MOSFET de type P mis en parallèle entre eux et connectés tous deux à la sortie de la cellule, la première entrée étant connectée aux grilles reliées d'un premier transistor de type P mis en parallèle, la seconde entrée étant connectée à la grille avant du second transistor de type P mis en parallèle dont les grilles sont séparées et à la grille avant du transistor de type P mis en série dont les grilles sont également séparées, deux signaux de contrôle appliqués sur les grilles arrière du second transistor de type P mis en parallèle et du transistor de type P mis en série permettant de rendre la cellule reconfigurable apte à réaliser quatre fonctions.

Selon une caractéristique avantageuse, pour ce type d'implémentation, les transistors étant tous symétriques, le rapport W/L du transistor de type P à grille séparée mis en parallèle est ajusté pour permettre le blocage de ce transistor lorsqu'une tension Vdd est appliquée sur sa grille arrière.

Selon une autre caractéristique avantageuse de l'invention, le transistor de type P à grille séparée mis en parallèle est asymétrique.

Avantageusement, tous les transistors sont asymétriques.

Concernant les modes de réalisation dans lesquels un ou des transistors asymétriques sont utilisés, préférentiellement, l'asymétrie des transistors est telle qu'elle permet l'augmentation de la tension de seuil de la grille avant, contrôlée par le signal logique d'entrée, par rapport à celle de la grille arrière, contrôlée par le signal de contrôle de la fonction logique de la cellule.

Avantageusement, l'asymétrie d'un (des) transistor(s) est choisie de manière à assurer un compromis entre la stabilité des modes de fonctionnement du(des) transistor(s) et les fonctions réalisées par la cellule avec des tensions de polarisation en dessous de la limite de claquage de grille du(des) transistor(s).

Pratiquement, l'asymétrie des transistors peut être réalisée avec des grilles asymétriques présentant des épaisseurs d'oxyde de grille différentes ou encore les grilles asymétriques sont telles qu'elles ont des fonctions de travail asymétriques.

De telles fonctions de travail asymétriques peuvent, par exemple, être réalisées en utilisant des matériaux distincts pour fabriquer les deux grilles des transistors concernés.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :
- la figure 1 représente un premier exemple de réalisation d'une cellule reconfigurable réalisée en logique dynamique selon l'invention ;
- la figure 2 est un chronogramme des fonctions NAND et NOR obtenues avec une cellule reconfigurable selon la figure 1 ;
- la figure 3 est un chronogramme des fonctions NON-A et NON-B obtenues avec une cellule reconfigurable selon la figure 1 ;
- la figure 4 représente un second exemple de réalisation d'une cellule reconfigurable réalisée en logique dynamique selon l'invention ;
- la figure 5 représente une généralisation de la réalisation d'une cellule reconfigurable réalisée en logique dynamique selon l'invention ;
- la figure 6 représente une réalisation d'une cellule reconfigurable réalisée en logique statique de l'invention ;
- la figure 7 est un chronogramme des fonctions NAND, NOR, NON-A et NON-B obtenu avec une cellule reconfigurable en logique statique selon la figure 6 ;
- la figure 8 représente une généralisation de la réalisation d'une cellule reconfigurable réalisée en logique statique selon l'invention.

### Description détaillée d'un mode de réalisation

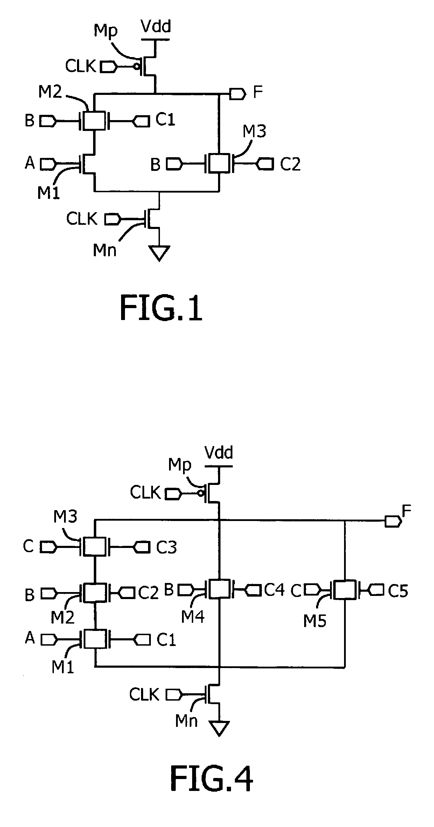

La figure 1 représente schématiquement une cellule reconfigurable dynamique à quatre fonctions logiques manipulant deux entrées A et B sur lesquelles sont fournis des signaux binaires susceptibles de prendre une valeur nulle « 0 » et une valeur non nulle « 1 ».

Le résultat de la fonction logique effectuée par la cellule reconfigurable est fourni sur une sortie F qui est la sortie de la cellule.

La cellule est réalisée selon une logique dynamique à partir d'un ensemble de dispositif MOSFET à double grille.

Dans l'exemple de réalisation de la figure 1, la cellule reconfigurable comprend cinq transistors MOSFET à double grille, notés M1 à M3, Mn et Mp.

Les transistors M1, Mn et Mp sont des dispositifs MOSFET double grille, symétriques, pour lesquelles les grilles avant et arrière sont connectées entre elles. Puisque ces transistors sont symétriques, leurs épaisseurs d'oxyde de grille et leurs fonctions de travail des grilles avant et arrière de ces transistors sont donc alors identiques.

Le transistor M2 est un dispositif double grille MOSFET symétrique à grille séparée. Le transistor M3 est un dispositif double grille MOSFET asymétrique présentant également des grilles séparées.

L'asymétrie du transistor M3 peut être réalisée en utilisant des épaisseurs différentes pour les oxydes de grille avant et arrière ou en donnant des fonctions de travail asymétriques aux deux grilles de ce transistor. De telles fonctions de travail distinctes peuvent être par exemple réalisées en utilisant deux matériaux différents pour les grilles avant et arrière.

Selon l'invention, les transistors M1 et M2 sont connectés en série sur une première branche de la cellule reconfigurable et le transistor M3 est placé sur une seconde branche mise en parallèle avec la première branche.

Les deux branches parallèles sont connectées en série avec les deux transistors Mn et Mp contrôlés avec un signal d'horloge CLK selon les principes utilisés en logique dynamique. Le transistor de précharge Mp est ainsi un transistor de type P alors que le transistor d'évaluation Mn est un transistor de type N.

La sortie de la cellule F correspond au point commun des deux branches connecté au transistor M5 et donc au point commun le plus éloigné de la masse.

Selon l'invention, l'entrée A de la cellule reconfigurable est connectée aux deux grilles du transistor M1. L'entrée B de la cellule reconfigurable est connectée aux grilles avant des transistors M2 et M3.

Deux signaux de contrôle C1 et C2, pouvant prendre les valeurs de tension Vdd, 0 et -Vdd, Vdd étant la tension d'alimentation, sont appliqués respectivement sur la grille arrière du transistor M2 et sur la grille arrière du transistor M3.

Ces signaux C1 et C2 permettent de modifier le mode de fonctionnement des transistors M2 et M3 et ainsi de modifier la fonction logique réalisée par la cellule reconfigurable.

Le tableau 1 ci-après résume l'ensemble des fonctions logiques pouvant être réalisées par la cellule reconfigurable de la figure 1 en modifiant les signaux de contrôle C1 et C2 appliqués sur les grilles arrière des transistors M2 et M3.

**Tableau 1**

| C1 | C2 | F |
|---|---|---|
| 0 | -Vdd | NAND |
| Vdd | 0 | NOR |
| Vdd | -Vdd | NON-A |
| -Vdd | 0 | NON-B |

Les tables de vérité des fonctions logiques NAND, NOR, NON-A et NON-B sont données dans le tableau 2.

**Tableau 2**

| A | B | NAND | NOR | NON-A | NON-B |
|---|---|---|---|---|---|
| 0 | 0 | 1 | 1 | 1 | 1 |
| 0 | 1 | 1 | 0 | 1 | 0 |
| 1 | 0 | 1 | 0 | 0 | 1 |
| 1 | 1 | 0 | 0 | 0 | 0 |

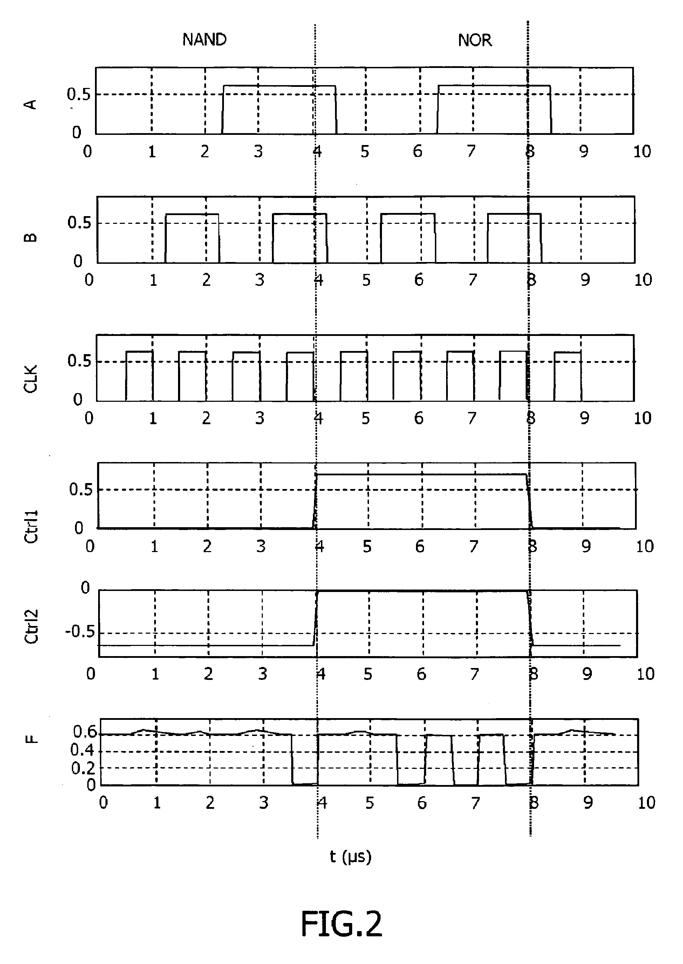

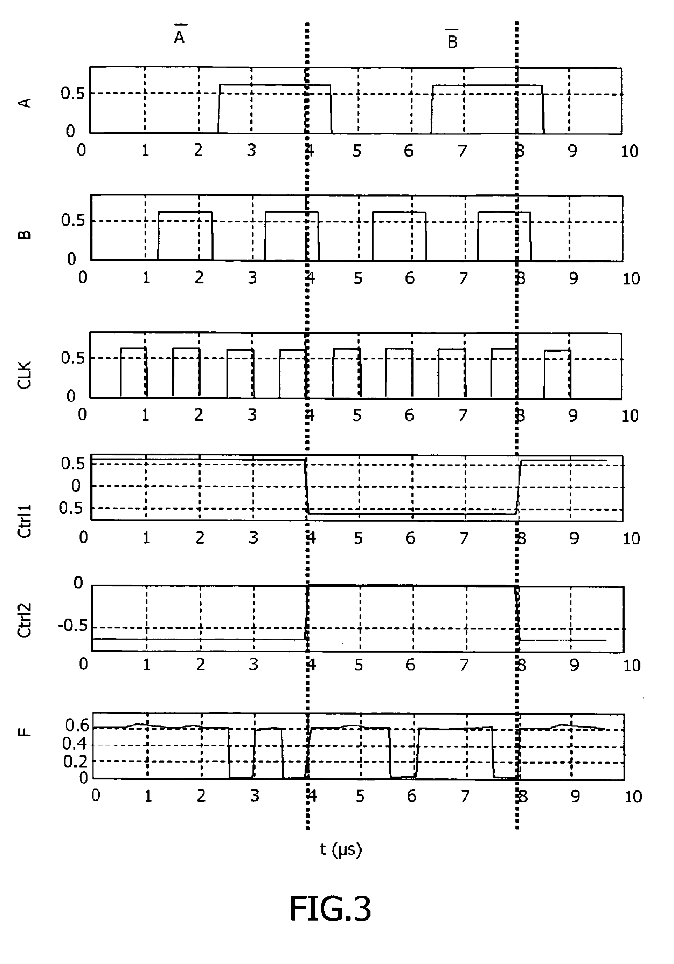

Les figures 2 et 3 sont des chronogrammes montrant le fonctionnement de la cellule reconfigurable de la figure 1 fonctionnant avec un Vdd égal à 0,6 volts et réalisé à partir uniquement de transistors asymétriques.

Sur ces chronogrammes, sont représentées en fonction du temps, les valeurs prises par les entrées A et B, par le signal d'horloge CLK, par les signaux de contrôle C1 et C2 ainsi que par la sortie F.

Les tensions des signaux sont donnés en volt et les transistors sont tous asymétriques et présentant des épaisseurs d'oxyde de grille avant et arrière, respectivement de 3,5 nanomètres et 1,2 nanomètres.

Les transistors M1 à M3 et Mn du réseau NMOS présentent tous la même taille, soit un W/L égal à 1,6 µm/0,4 µm dans l'exemple de réalisation de la figure 1. Le transistor de type P de précharge Mp présente, quant à lui, un W/L égal à 1 µm/0,4 µm.

L'identité de taille des transistors NMOS permet une fabrication simple de la cellule reconfigurable, à partir d'un ensemble de transistors asymétriques fabriqués en même temps. Dans ce cas, l'entrée B appliquée sur le transistor M3 de la deuxième branche de la cellule reconfigurable est connectée à la grille ayant l'oxyde de grille le plus épais.

Dans la première partie du chronogramme, le signal C1 est égal à 0 volts alors que le signal C2 est égal à -Vdd=-0,6 volts. La cellule reconfigurable réalise alors la fonction logique NAND.

Dans cette configuration, la tension nulle appliquée grâce au signal C1, confère au transistor M2 un mode de fonctionnement « normal ». Cela signifie que le transistor M2 est conducteur lorsqu'un niveau logique 1 est appliqué sur la grille avant et bloqué lorsqu'un niveau logique zéro est appliqué sur cette même grille avant.

L'application d'un signal C2 égal à -Vdd permet de bloquer complètement le transistor M3 et ce, indépendamment de la tension appliquée sur la grille avant.

Un tel blocage complet du transistor M3 n'est possible que si ce transistor est asymétrique.

En effet, l'asymétrie est telle que la tension de seuil de la grille avant est augmentée de manière à ce que lorsqu'un signal de contrôle C1 égal à -Vdd est appliqué, quel que soit le signal appliqué sur cette grille avant, le transistor M3 ne devienne pas conducteur dans cette configuration permettant de réaliser la fonction NAND.

Néanmoins, la tension de seuil de la grille avant doit rester suffisamment basse pour permettre un mode de fonctionnement normal du transistor M3 lorsque le signal C2 est nul.

Cela est notamment le cas dans la configuration permettant de réaliser la fonction NOR où le signal C1 présente une tension Vdd et où le signal C2 présente une tension nulle.

Un tel signal C1 permet de réduire, de manière significative, la tension de seuil du transistor M2 et de le rendre conducteur quel que soit l'état logique du signal appliqué sur sa grille avant.

Le signal C2 de tension nulle assure une conduction « normale » du transistor M3, c'est-à-dire que M3 est conducteur lorsqu'un niveau logique 1 est appliqué sur la grille avant et bloqué lorsqu'un niveau logique 0 est appliqué sur la grille avant du transistor M3.

Les figures 2 et 3 présentent des chronogrammes obtenus avec la cellule reconfigurable de la figure 1.

Le transistor M3 est toujours bloqué lorsqu'une tension -Vdd est appliquée sur la grille arrière. Dans le cas d'un transistor M3 symétrique, il ne serait pas complètement bloqué.

L'augmentation de l'épaisseur d'oxyde de grille avant ou encore l'utilisation d'une fonction de travail plus élevée pour la grille avant permet d'augmenter la tension de seuil de la grille avant dans le transistor M3 asymétrique. En diminuant le contrôle sur cette grille, on assure le blocage complet du transistor M3, y compris lorsque l'entrée B a un état logique 1.

Les chronogrammes présentés sur les figures 2 et 3 ont été obtenus avec une différence d'épaisseur d'oxyde de grille arrière/avant allant approximativement du simple au triple, soit 1,2 nanomètres pour la grille arrière et 3,5 nanomètres pour la grille avant.

L'importance de l'asymétrie entre les deux grilles dépend de la tension d'alimentation Vdd. En général, on observe que l'on peut abaisser le rapport épaisseur d'oxyde de grille arrière sur épaisseur d'oxyde de grille avant jusqu'à 0,5.

Cela signifie que, par exemple, sous une tension d'alimentation Vdd égale à 0,6 volts, avec une grille arrière de 1,2 nanomètres d'épaisseur, on peut abaisser l'épaisseur de grille avant jusqu'à environ 2,4 nanomètres.

Cela permet en outre de gagner légèrement en performance puisque la diminution de l'épaisseur de l'oxyde de grille avant permet d'obtenir une tension de seuil plus faible.

La figure 4 représente un deuxième exemple de réalisation d'une cellule reconfigurable selon l'invention.

Cette cellule reconfigurable à trois entrées est apte à implémenter onze fonctions logiques et utilise sept transistors double grille MOSFET.

Plus précisément, outre les transistors Mn et Mp permettant de gérer le signal d'horloge selon les principes de la logique dynamique, trois transistors M1, M2 et M3 sont mis en série sur une première branche et deux branches parallèles à la première branche comprennent chacune un transistor, respectivement M4 et M5.

Les transistors M1 à M5 reçoivent chacun sur leur grille avant une entrée parmi les trois entrées A, B, C de la cellule reconfigurable.

Chacun de ces transistors est par ailleurs connecté par sa grille arrière à un signal de contrôle. Ainsi, cinq signaux de contrôle C1 à C5 sont nécessaires pour contrôler les modes de fonctionnement des transistors M1 à M5.

Le tableau 3 représente la table de vérité de la cellule reconfigurable à onze fonctions représentées sur la figure 4.

**Tableau 3**

| C1 | C2 | C3 | C4 | C5 | F |
|---|---|---|---|---|---|
| 0 | 0 | 0 | -Vdd | -Vdd | A̅.̅B̅.̅C̅ |
| Vdd | Vdd | 0 | 0 | 0 | A̅+̅B̅+̅C̅ |
| Vdd | Vdd | 0 | 0 | -Vdd | A̅+̅B̅ |
| Vdd | Vdd | 0 | -Vdd | 0 | A̅+̅C̅ |
| Vdd | 0 | Vdd | -Vdd | 0 | B̅+̅C̅ |
| Vdd | 0 | 0 | -Vdd | -Vdd | A̅.̅B̅ |
| 0 | 0 | Vdd | -Vdd | -Vdd | B̅.̅C̅ |
| 0 | Vdd | 0 | -Vdd | -Vdd | A̅.̅C̅ |
| Vdd | Vdd | 0 | -Vdd | -Vdd | A̅ |
| Vdd | 0 | Vdd | -Vdd | -Vdd | B̅ |
| 0 | Vdd | Vdd | -Vdd | -Vdd | C̅ |

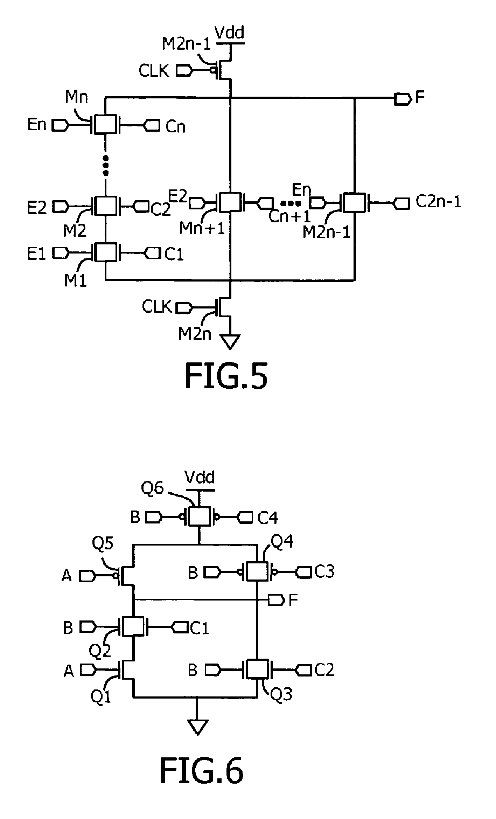

La figure 5 représente une généralisation du principe de l'invention permettant de réaliser une cellule reconfigurable à n entrées E1 à En.

La cellule reconfigurable de la figure 5 comprend une première branche portant n transistors MOSFET double grille à grille indépendante M1 à Mn.

Les grilles avant de ces n transistors M1 à Mn sont contrôlées par les n entrées logiques du réseau E1 à En et les grilles arrières de ces n transistors sont contrôlées par des signaux de contrôle C1 à Cn.

La cellule reconfigurable comprend en outre n-1 branches parallèles à la première branche et comprenant chacune un transistor double grille MOSFET asymétrique Mn+1 à M2n-1, par exemple présentant une épaisseur d'oxyde de grille avant supérieure à l'épaisseur de l'oxyde de grille arrière.

Les grilles avant de ces transistors sont chacune connectées à une de n-1 entrées E2 à En.

2n-1 signaux de contrôle C1 à C2n-1 des grilles arrière de tous ces transistors sont nécessaires pour commander les configurations de la cellule reconfigurable.

On constate que les cellules reconfigurables réalisées en logique dynamique présentées sur les figures précédentes sont particulièrement compactes. En effet, la structure dynamique ne nécessite pas de réseaux complémentaires de type P et permet donc de garder une grande compacité.

L'absence du réseau complémentaire permet également de réduire les capacités parasites et autorise une plus grande vitesse en comparaison avec la structure statique complémentaire.

Néanmoins, les logiques statiques présentent en général une meilleure immunité au bruit que les logiques dynamiques et sont par conséquent, particulièrement intéressantes pour les applications où la température peut varier de façon significative.

La logique statique CMOS (SCMOS) nécessite, en plus du réseau NMOS présenté sur les figures précédentes, un réseau de type P complémentaire.

Malgré l'encombrement généré par un tel réseau complémentaire PMOS en termes de surface et de capacité parasite, dans le cas d'implémentation de fonctions logiques avec un nombre important d'entrées, la logique statique peut être intéressante dans les applications militaires ou encore dans les applications utilisées dans les puits de pétrole.

La figure 6 présente une cellule statique reconfigurable à quatre fonctions logiques. Elle est réalisée à partir de six transistors.

Dans cette cellule reconfigurable, on retrouve les deux branches utilisées en logique dynamique avec la sortie F pratiquée sur le point commun aux deux branches le plus éloigné de la masse. La première branche porte deux transistors Q1 et Q2 symétriques ou asymétriques en série, la seconde, un transistor Q3, préférentiellement asymétrique.

Un réseau complémentaire de transistors PMOS Q4, Q5 et Q6 est implémenté entre la sortie F et la borne d'alimentation Vdd. Dans ce réseau, lorsqu'une branche NMOS correspondante est bloquée, la (ou les) branche(s) PMOS complémentaires est(sont) conductrice(s).

Les transistors Q4 et Q5 sont connectés en parallèle l'un de l'autre et mis en série avec le transistor Q6 connecté à la borne d'alimentation. La sortie F est donc située au point commun aux deux réseaux de transistors.

Le transistor Q5 est un transistor MOSFET double grille symétrique ou asymétrique de type P où les grilles sont connectées entre elles.

Les transistors Q4 et Q6 sont des transistors MOSFET double grille asymétrique PMOS à grilles séparées, contrôlés par deux signaux de contrôle C3 et C4 sur leur grille arrière.

L'entrée A est connectée aux grilles reliées du transistor Q5.

L'entrée B est connectée aux grilles avant des transistors Q4 et Q6.

La cellule reconfigurable, représentée sur la figure 6, peut être réalisée à partir uniquement de transistors symétriques ou uniquement de transistors asymétriques.

Dans l'exemple proposé sur la figure 6, les dimensions des transistors sont de W/L=1,6 µm/0,4 µm pour les transistors Q1, Q2 et Q3, de W/L=3,2 µm/0,4 µm pour les transistors Q5 et Q6 et de W/L=0,8 µm/0,5 µm pour le transistor Q4.

Sauf si la cellule fonctionne sous une tension d'alimentation Vdd supérieure à 0,6 volts, l'utilisation de transistors symétriques pour toute la cellule reconfigurable statique permet un fonctionnement correct.

Il est en effet nécessaire que le rapport de la tension d'alimentation Vdd sur la tension de seuil Vs des transistors Q3 et Q4 soit suffisamment faible et cela est le cas lorsque Vdd est égal à 0,6 volt et la tension de seuil du dispositif symétrique est égale à environ 0,4 volt. Cette faiblesse du rapport Vdd/Vs permet, à elle seule, d'assurer le blocage du transistor Q3 avec uniquement l'application de la tension - Vdd sur la grille arrière.

En ce qui concerne le transistor Q4, l'utilisation d'un rapport W/L faible et d'un rapport Vdd/Vs relativement faible suffisent, avec un contrôle adéquat sur la grille arrière, pour assurer un blocage et donc une fonctionnalité correcte de la cellule.

Néanmoins, dans le cas où l'on s'intéresse à des cellules reconfigurables statiques plus orientées, haute vitesse que basse consommation, il est alors utile de choisir une tension d'alimentation proche de la tension maximale spécifiée par le fabricant de transistors. La tension d'alimentation peut alors, par exemple, être égale à 1,2 volts.

Dans un tel cas, et dès lors que la tension d'alimentation est supérieure à 0,6 volts, l'utilisation de transistors double grille MOSFET asymétrique pour les transistors Q3 et Q4 est nécessaire pour permettre le blocage dans les configurations qui le nécessite quelle que soit la tension fournie sur leur grille avant. Dans un tel cas, comme pour la cellule implémentée en logique dynamique, l'ensemble de la cellule peut aussi être réalisé à l'aide uniquement de transistors asymétriques.

L'ajustement des rapports Epaisseur d'oxyde de grille avant/Epaisseur d'oxyde de grille arrière des transistors asymétriques est avantageusement choisi de manière à respecter cette condition de blocage tout en maintenant des tensions Vgs et Vgd des transistors concernés inférieures à 1,2 volts pour éviter tout risque de claquage des oxydes de grille.

Le tableau 4 représente la table de vérité de la cellule reconfigurable statique de la figure 6 permettant de réaliser quatre fonctions logiques, chacune des fonctions disponibles correspondant à une configuration donnée dépendante de l'état des signaux de contrôle C1 à C4.

**Tableau 4**

| C1 | C2 | C3 | C4 | F |
|---|---|---|---|---|
| Vdd | -Vdd | Vdd | -Vdd | A̅ |
| -Vdd | 0 | -Vdd | Vdd | B̅ |
| 0 | -Vdd | Vdd | -Vdd | A̅.̅B̅ |
| Vdd | 0 | Vdd | Vdd | A̅+̅B̅ |

Les quatre fonctions logiques implémentées sont identiques à celles présentées pour la cellule reconfigurable de la figure 1.

Le fonctionnement de la cellule reconfigurable de la figure 6 permet donc de réaliser quatre fonctions logiques : NON-A, NON-B, NAND et NOR.

Dans la configuration NON-A, le signal C1 présente une tension égale à Vdd, de manière à rendre le transistor Q2 conducteur quelle que soit la tension appliquée sur la grille avant de Q2, donc quel que soit l'état logique du signal B. Le signal C2 a une tension égale à -Vdd de manière à bloquer le transistor Q3, quelle que soit la tension appliquée sur la grille avant, c'est-à-dire quel que soit l'état logique du signal B. Comme le transistor Q3 est asymétrique, il est donc ainsi complètement bloqué.

Le signal C3 présente une tension égale à Vdd pour bloquer le transistor PMOS Q4 en permanence. En réalité le blocage du transistor Q4 dépend de la polarisation du transistor Q4 lui-même et de la polarisation du ou des transistors en série sur la même branche. Au besoin, le transistor Q4 est choisi asymétrique. Un tel dispositif Q4 présente alors par exemple une épaisseur d'oxyde de grille avant plus élevée que l'épaisseur d'oxyde de grille arrière.

Le signal C4 présente une tension égale à -Vdd afin d'assurer que le transistor Q6 est conducteur indépendamment de l'état logique de l'entrée B qui est appliquée sur sa grille avant.

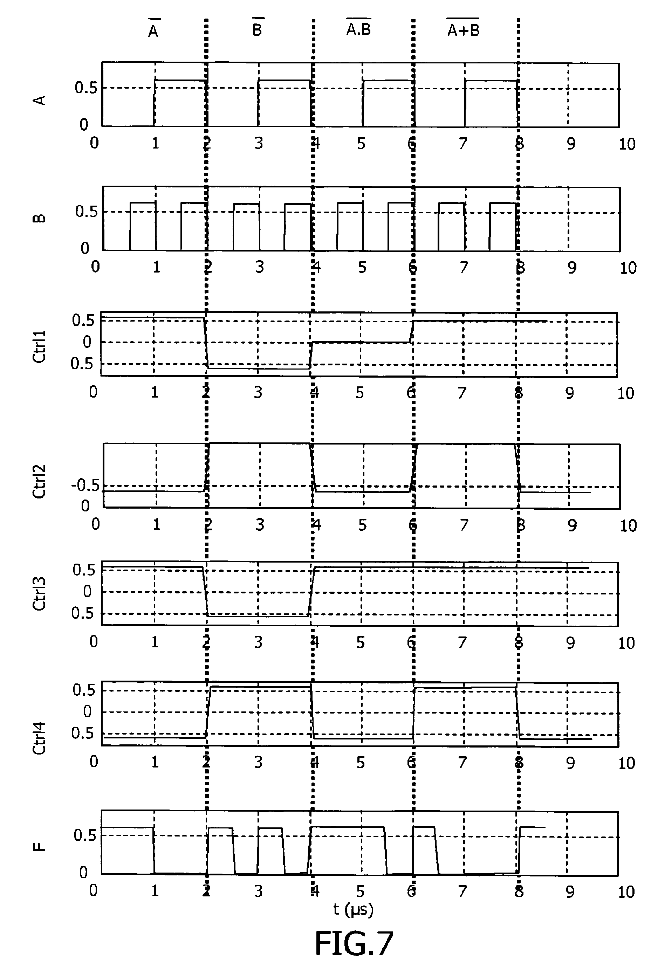

La figure 7 représente un chronogramme de la cellule reconfigurable statique à quatre fonctions de la figure 6 pour chacune des quatre fonctions réalisées par cette cellule. La réalisation de ces fonctions nécessitent de pouvoir mettre les transistors en capacité de conduire le courant ou de le bloquer quel que soit l'état logique sur la grille avant à l'aide d'une tension appliquée sur la grille arrière.

Pour la configuration NON-B, le signal de contrôle C1 présente une tension - Vdd pour bloquer la branche où se trouve le transistor Q1 de type NMOS, contrôlé par l'entrée A. Le signal de contrôle C2 est pris égal à 0 volt afin d'assurer une conduction normale du transistor Q3.

Pour assurer la conduction du transistor Q4 quel que soit l'état logique de l'entrée B, le signal de contrôle C3 est pris égal à -Vdd afin de réduire, de manière significative, la tension de seuil du transistor Q4 et de réduire sa résistance R_{ON}. Le transistor Q4 est alors conducteur quel que soit l'état logique de l'entrée B.

Enfin, le signal de contrôle C4 est pris égal à Vdd pour assurer une conduction normale du transistor Q6, c'est-à-dire que ce transistor est conducteur lorsqu'un état logique 0 est fourni sur sa grille avant et bloqué lorsqu'un état logique 1 est fourni sur sa grille avant.

Pour réaliser la fonction NAND, le signal de contrôle C1 présente une tension égale à 0 volt pour assurer une conduction normale du transistor Q2, le signal C2 présente une tension égale à -Vdd de manière à bloquer le transistor Q3 au besoin en combinaison avec une structure asymétrique de ce transistor. Le signal de contrôle C3 présente une tension égale à Vdd afin d'assurer une conduction normale du transistor Q4 et le signal de contrôle C4 présente une tension égale à -Vdd de manière à rendre conducteur le transistor Q6 quelle que soit la tension appliquée sur sa grille avant et donc quel que soit l'état logique de l'entrée B.

Enfin, afin de réaliser la fonction NOR, le signal de contrôle C1 présente une tension égale à Vdd afin d'assurer la conduction du transistor Q2, quelque soit la tension appliquée sur la grille avant de ce transistor. Le signal de contrôle C2 est pris de tension nulle afin d'assurer au transistor Q3 un comportement normal, fonction des états logiques pris par l'entrée B. Le signal de contrôle C3 est pris de tension égale à Vdd assurant un blocage permanent du transistor Q4 au besoin en combinaison avec un ajustement de ses dimensions et un caractère asymétrique de ce transistor. Par exemple, l'épaisseur de l'oxyde de grille contrôlée par l'entrée B peut être augmentée. On augmente ainsi la tension de seuil du transistor Q4 et le fonctionnement en régime de blocage est obtenu.

Le signal de contrôle C4 est enfin pris de tension égale à Vdd afin d'assurer une conduction normale du transistor Q6.

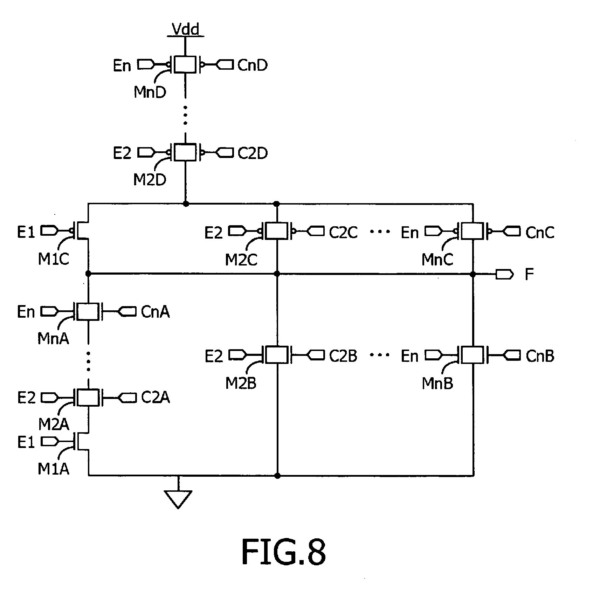

La figure 8 représente une généralisation du principe de l'invention permettant de réaliser une cellule statique reconfigurable à n entrées E1 à En.

La cellule reconfigurable de la figure 8 comprend une première branche portant n transistors MOSFET M1A à MnA en série.

Le transistor M1A est un transistor MOSFET double grille, symétrique et dont les grilles avant et arrière sont connectées entre elles, tandis que les n-1 transistors M2A à MnA sont des transistors MOSFET double grille, symétriques et à grilles séparées.

Les deux grilles du transistor M1A sont contrôlées par l'entrée logique du réseau E1. Les grilles avant des n-1 transistors M2A à MnA sont contrôlées par les n-1 entrées logiques du réseau E2 à En, tandis que les grilles arrière de ces n-1 transistors sont contrôlées par des signaux de contrôle C2A à CnA.

La cellule reconfigurable comprend en outre n-1 branches parallèles à la première branche et comprenant chacune un transistor MOSFET M2B à MnB.

Les n-1 transistors M2B à MnB sont des transistors MOSFET double grille, préférentiellement asymétriques, à grilles séparées.

Les grilles avant des n-1 transistors M2B à MnB sont contrôlées par les n-1 entrées logiques du réseau E2 à En, tandis que les grilles arrière de ces n-1 transistors sont contrôlées par des signaux de contrôle C2B à CnB.

La sortie F est pratiquée sur le point commun aux n branches le plus éloigné de la masse.

Un réseau complémentaire de transistors PMOS est implémenté entre la sortie F et la borne d'alimentation Vdd. Dans ce réseau, lorsqu'une branche NMOS correspondante est bloquée, la (ou les) branche(s) PMOS complémentaire(s) est (sont) conductrice(s).

Ce réseau complémentaire comprend n transistors M1C à MnC connectés en parallèle les uns des autres et mis en série avec n-1 transistors M2D à MnD, MnD étant connecté à la borne d'alimentation.

La sortie F est donc située au point commun des deux réseaux de transistors.

Le transistor M1C est un transistor MOSFET double grille, symétrique ou asymétrique, de type P dont les grilles sont connectées entre elles, tandis que les n-1 transistors M2C à MnC sont des transistors MOSFET double grille PMOS, asymétriques et à grilles séparées.

Les deux grilles du transistor M1C sont contrôlées par l'entrée logique du réseau E1. Les grilles avant des n-1 transistors M2C à MnC sont contrôlées par les n-1 entrées logiques du réseau E2 à En, tandis que les grilles arrière de ces n-1 transistors sont contrôlées par des signaux de contrôle C2C à CnC.

Les transistors M2D à MnD sont des transistors MOSFET double grille PMOS, symétriques et à grilles séparées. Les grilles avant des n-1 transistors M2D à MnD sont contrôlées par les n-1 entrées logiques du réseau E2 à En, tandis que les grilles arrière de ces n-1 transistors sont contrôlées par des signaux de contrôle C2D à CnD.

Il est à noter que la cellule reconfigurable représentée sur la figure 8 peut être réalisée uniquement à partir de transistors symétriques ou uniquement à partir de transistors asymétriques.

4(n-1) signaux de contrôles (C2A à CnA, C2B à CnB, C2C à CnC et C2D à CnD) des grilles arrière de tous ces transistors sont nécessaires pour commander les configurations de la cellule reconfigurable.

On remarque enfin que diverses mises en oeuvre peuvent être réalisées selon les principes de l'invention définis dans les revendications qui suivent.

## Revendications

1. Cellule logique reconfigurable comprenant n entrées (A,B,...), n étant supérieur ou égal à 2, et apte à réaliser au moins quatre fonctions logiques permettant de traiter des signaux logiques fournis sur les n entrées (A,B,...), ladite cellule logique comprenant entre la masse et la sortie (F) de la cellule, au moins une première branche comportant n transistors (M1,M2,...) MOSFET de type N à double grille en série et n-1 branches en parallèle de la première branche pourvues chacune d'un transistor (M3) MOSFET de type N à double grille, chacune des fonctions logiques correspondant à une configuration donnée de la cellule où un ensemble spécifique de signaux de contrôle (C1,C2,...) est appliqué sur les grilles arrière d'au moins une partie des transistors (M2,M3,...), chaque signal de contrôle (C1,C2,...) étant apte à mettre le transistor (M2,M3,...) dans un mode de fonctionnement particulier, les n entrées (A,B,...) étant connectées chacune sur la grille avant d'un des n transistors (M1,M2,...) de la première branche, n-1 entrées (B) étant aussi appliquées sur la grille avant d'un (M3) des n-1 transistors des n-1 branches en parallèle de la première branche.

2. Cellule reconfigurable selon la revendication 1, **caractérisée en ce que** n est égal à 2, une première entrée (A) étant connectée aux grilles reliée d'un premier transistor (M1) de la première branche, une seconde entrée (B) étant connectée à la grille avant du second transistor (M2) de la première branche dont les grilles sont séparées et à la grille avant du transistor (M3) de la seconde branche dont les grilles sont également séparées, des signaux de contrôle (C1,C2) appliqués sur les grilles arrière du second transistor (M2) de la première branche et du transistor (M3) de la seconde branche permettant de rendre la cellule reconfigurable apte à réaliser quatre fonctions.

3. Cellule reconfigurable selon la revendication 1, **caractérisée en ce que** n est égal à 3, tous les transistors étant à grilles séparées, une première entrée (A) étant connectée à la grille avant d'un premier transistor (M1) de la première branche, une deuxième entrée (B) étant connectée à la grille avant d'un deuxième transistor (M2) de la première branche et à la grille avant du transistor de la deuxième branche (M4), une troisième entrée (C) étant connectée à la grille avant du troisième transistor (M3) de la première branche et à la grille avant du transistor (M5) de la troisième branche, cinq signaux de contrôle (C1 à C5) appliqués sur les grilles arrière des cinq transistors (M1 à M5) permettant de rendre la cellule reconfigurable apte à réaliser onze fonctions.

4. Cellule reconfigurable selon l'une des revendications précédentes, **caractérisée en ce que** les signaux de contrôle (C1, C2, ...) présentent une tension choisie parmi -Vdd, 0, +Vdd, Vdd étant la tension d'alimentation de la cellule.

5. Cellule reconfigurable selon l'une des revendications 1 à 4, **caractérisée en ce qu'**elle est implémentée en logique dynamique, les branches de la cellule étant mises en série, entre la masse et une borne d'alimentation, entre un transistor de précharge de type P (Mp) et un transistor d'évaluation de type N (Mn), dont les grilles sont commandées par un signal d'horloge et **en ce que** les transistors (M3,M4 et M5) des n-1 branches en parallèle de la première branche sont asymétriques.

6. Cellule reconfigurable selon la revendication 5, **caractérisée en ce que** tous les transistors sont asymétriques.

7. Cellule reconfigurable selon l'une des revendications 1 à 5, **caractérisée en ce qu'**elle est implémentée en logique statique, les branches de la cellule étant mise en série entre la masse et une borne d'alimentation (Vdd) avec un réseau complémentaire de transistors placé entre le point commun aux branches de la cellule le plus éloigné de la masse constituant la sortie (F) de la cellule et la borne d'alimentation (Vdd).

8. Cellule reconfigurable selon les revendications 2 et 7, **caractérisée en ce que** n étant égal à 2, le réseau complémentaire comprend, entre la borne d'alimentation et la sortie (F) de la cellule, un transistor (Q6) MOSFET de type P en série avec deux transistors (Q4,Q5) MOSFET de type P mis en parallèle entre eux et connectés tous deux à la sortie (F) de la cellule, la première entrée (A) étant connectée aux grilles reliées d'un premier transistor (Q5) de type P mis en parallèle, la seconde entrée (B) étant connectée à la grille avant du second transistor (Q4) de type P mis en parallèle dont les grilles sont séparées et à la grille avant du transistor (Q6) de type P mis en série dont les grilles sont également séparées, deux signaux de contrôle (C3,C4) appliqués sur les grilles arrière du second transistor (Q4) de type P mis en parallèle et du transistor (Q6) de type P mis en série permettant de rendre la cellule reconfigurable apte à réaliser quatre fonctions.

9. Cellule reconfigurable selon la revendication 8, **caractérisée en ce que**, les transistors étant tous symétriques, le rapport W/L du transistor (Q4) de type P à grilles séparées mis en parallèle est ajusté pour permettre le blocage de ce transistor lorsqu'une tension Vdd est appliquée sur sa grille arrière.

10. Cellule reconfigurable selon la revendication 8, **caractérisée en ce que** le transistor (Q4) de type P à grilles séparées mis en parallèle est asymétrique.

11. Cellule reconfigurable selon la revendication 10, **caractérisée en ce que** tous les transistors sont asymétriques.

12. Cellule reconfigurable selon l'une des revendications 5, 6, 10 et 11, précédentes, **caractérisée en ce que** l'asymétrie des transistors est telle qu'elle permet l'augmentation de la tension de seuil de la grille avant, contrôlée par le signal logique d'entrée, par rapport à celle de la grille arrière, contrôlée par le signal de contrôle de la fonction logique de la cellule.

13. Cellule reconfigurable selon l'une des revendications 5, 6, 10, 11 et 12, **caractérisée en ce que** l'asymétrie d'un (des) transistor(s) est choisie de manière à assurer un compromis entre la stabilité des modes de fonctionnement du(des) transistor(s) et les fonctions réalisées par la cellule avec des tensions de polarisation en dessous de la limite de claquage de grille du(des) transistor(s).

14. Cellule reconfigurable selon l'une des revendications précédentes, **caractérisée en ce que** les grilles asymétriques présentent des épaisseurs d'oxyde de grille différentes.

15. Cellule reconfigurable selon l'une des revendications précédentes, **caractérisée en ce que** les grilles asymétriques sont telles qu'elles ont des fonctions de travail asymétriques.

## Claims

1. A reconfigurable logic cell comprising n inputs (A,B,...), n being greater than or equal to 2, and capable of producing at least four logic functions with which logic signals provided on the n inputs (A,B,...) may be processed, said logic cell comprising, between the ground and the output (F) of the cell, at least one first branch including n dual gate N type MOSFET transistors (M1,M2,...) in series and n-1 branches in parallel with the first branch, each provided with one dual gate N type MOSFET transistor (M3), each of the logic functions corresponding to a given configuration of the cell wherein a specific set of control signals (C1,C2,...) is applied on the rear gates of at least one portion of the transistors (M2,M3,...), each control signal (C1,C2,...) being capable of setting the transistor (M2,M3,...) to a particular operating mode, the n inputs (A,B,...) being each connected on the front gate of one of the n transistors (M1,M2,...) of the first branch, n-1 inputs (B) being also applied on the front gate of one (M3) of the n-1 transistors of the n-1 branches in parallel with the first branch.

2. The reconfigurable cell according to claim 1, **characterized in that** n is equal to 2, a first input (A) being connected to the connected gates of a first transistor (M1) of the first branch, a second input (B) being connected to the front gate of the second transistor (M2) of the first branch, the gates of which are separate, and to the front gate of the transistor (M3) of the second branch, the gates of which are also separate; control signals (C1,C2) applied on the rear gates of the second transistor (M2) of the first branch and of the transistor (M3) of the second branch enabling the reconfigurable cell to be made capable of performing four functions.

3. The reconfigurable cell according to claim 1, **characterized in that** n is equal to 3, all the transistors being with separate gates, a first input (A) being connected to the front gate of a first transistor (M1) of the first branch, a second input (B) being connected to the front gate of a second transistor (M2) of the first branch and to the front gate of the transistor of the second branch (M4), a third input (C) being connected to the front gate of the third transistor (M3) of the first branch and to the front gate of the transistor (M5) of the third branch, five control signals (C1 to C5) applied on the rear gates of the five transistors (M1 to M5) enables the reconfigurable cell to be made capable of performing eleven functions.

4. The reconfigurable cell according to any preceding claim, **characterized in that** the control signals (C1,C2,...) have a voltage selected from -Vdd, 0, +Vdd, Vdd being the power supply voltage of the cell.

5. The reconfigurable cell according to one of claims 1 to 4, **characterized in that** it is implemented in dynamic logic, the branches of the cell being placed in series, between the ground and a power supply terminal, between a preload transistor of the P type (Mp) and an evaluation transistor of the N type (Mn), the gates of which are controlled by a clock signal and **in that** the transistors (M3,M4 and M5) of the n-1 branches in parallel with the first branch are asymmetrical.

6. The reconfigurable cell according to claim 5, **characterized in that** all the transistors are asymmetrical.

7. The reconfigurable cell according to one of claims 1 to 5, **characterized in that** it is implemented in static logic, the branches of the cell being placed in series between the ground and a power supply terminal (Vdd) with a complementary network of transistors placed between the point common to the branches of the cell, the most distant from the ground, forming the output (F) of the cell, and the power supply terminal (Vdd).

8. The reconfigurable cell according to claims 2 and 7, **characterized in that** n being equal to 2, the complementary network comprises, between the power supply terminal and the output (F) of the cell, a P type MOSFET transistor (Q6) in series with two P type MOSFET transistors (Q4,Q5) placed in parallel with each other and both connected to the output (F) of the cell, the first input (A) being connected to the connected gates of a first P type transistor (Q5) placed in parallel, the second input (B) being connected to the front gate of the second P type transistor (Q4) placed in parallel, the gates of which are separate, and to the front gate of the P type transistor (Q6) placed in series, the gates of which are also separate; two control signals (C3,C4) applied on the rear gates of the second P type transistor (Q4) placed in parallel and of the P type transistor (Q6) placed in series enabling the reconfigurable cell to be made capable of performing four functions.

9. The reconfigurable cell according to claim 8, **characterized in that** as the transistors are all symmetrical, the W/L ratio of the P type transistor (Q4) with separate gates placed in parallel is adjusted so as to allow blocking of this transistor when a voltage Vdd is applied on its rear gate.

10. The reconfigurable cell according to claim 8, **characterized in that** the P type transistor (Q4) with separate gates placed in parallel is asymmetrical.

11. The reconfigurable cell according to claim 10, **characterized in that** all the transistors are asymmetrical.

12. The reconfigurable cell according to any preceding claim 5, 6, 10 and 11, **characterized in that** the asymmetry of the transistors is such that it allows increase in the threshold voltage of the front gate, controlled by the input logic signal, relatively to that of the rear gate, controlled by the control signal of the logic function of the cell.

13. The reconfigurable cell according to one of claims 5, 6, 10, 11 and 12, **characterized in that** the asymmetry of one of the transistor(s) is selected so as to ensure a compromise between the stability of the operating modes of the transistor(s) and the functions produced by the cell with bias voltages below the gate breakdown limit of the transistor(s).

14. The reconfigurable cell according to any preceding claim, **characterized in that** the asymmetrical gates have different gate oxide thicknesses.

15. The reconfigurable cell according to any preceding claim, **characterized in that** the asymmetrical gates are such that they have asymmetrical work functions.

## Patentansprüche

1. Rekonfigurierbare Logikzelle, welche n Eingänge (A, B, ...) umfaßt, wobei n größer oder gleich 2 ist, und die geeignet ist, mindestens vier logische Funktionen auszuführen, die es ermöglichen, logische Signale zu verarbeiten, die den n Eingängen (A, B, ...) zugeführt werden, wobei die Logikzelle zwischen der Masse und dem Ausgang (F) der Zelle mindestens einen ersten Zweig, der n Doppelgate-MOSFET-Transistoren (M1, M2, ...) mit N Kanälen in Reihe aufweist, und n-1 zu dem ersten Zweig parallele Zweige, die jeweils mit einem Doppelgate-MOSFET-Transistor (M3) mit N Kanälen versehen sind, umfaßt, wobei jede der logischen Funktionen einer gegebenen Konfiguration der Zelle entspricht, bei der eine spezielle Menge von Steuersignalen (C1, C2, ...) an die hinteren Gates wenigstens eines Teils der Transistoren (M2, M3, ...) angelegt wird, wobei jedes Steuersignal (C1, C2, ...) geeignet ist, den Transistor (M2, M3, ...) in eine spezielle Betriebsart zu versetzen, wobei die n Eingänge (A, B, ...) jeweils mit dem vorderen Gate eines der n Transistoren (M1, M2, ...) des ersten Zweiges verbunden sind, wobei n-1 Eingänge (B) auch an das vordere Gate eines (M3) der n-1 Transistoren der n-1 zu dem ersten Zweig parallelen Zweige angelegt sind.

2. Rekonfigurierbare Zelle nach Anspruch 1, **dadurch gekennzeichnet, daß** n gleich 2 ist, wobei ein erster Eingang (A) mit den verbundenen Gates eines ersten Transistors (M1) des ersten Zweiges verbunden ist, wobei ein zweiter Eingang (B) mit dem vorderen Gate des zweiten Transistors (M2) des ersten Zweiges, dessen Gates getrennt sind, und mit dem vorderen Gate des Transistors (M3) des zweiten Zweiges, dessen Gates ebenfalls getrennt sind, verbunden ist, wobei Steuersignale (C1, C2), die an die hinteren Gates des zweiten Transistors (M2) des ersten Zweiges und des Transistors (M3) des zweiten Zweiges angelegt werden, ermöglichen, die rekonfigurierbare Zelle in die Lage zu versetzen, vier Funktionen auszuführen.

3. Rekonfigurierbare Zelle nach Anspruch 1, **dadurch gekennzeichnet, daß** n gleich 3 ist, wobei alle Transistoren getrennte Gates aufweisen, wobei ein erster Eingang (A) mit dem vorderen Gate eines ersten Transistors (M1) des ersten Zweiges verbunden ist, wobei ein zweiter Eingang (B) mit dem vorderen Gate eines zweiten Transistors (M2) des ersten Zweiges und mit dem vorderen Gate des Transistors (M4) des zweiten Zweiges verbunden ist, wobei ein dritter Eingang (C) mit dem vorderen Gate des dritten Transistors (M3) des ersten Zweiges und mit dem vorderen Gate des Transistors (M5) des dritten Zweiges verbunden ist, wobei fünf Steuersignale (C1 bis C5), die an die hinteren Gates der fünf Transistoren (M1 bis M5) angelegt werden, ermöglichen, die rekonfigurierbare Zelle in die Lage zu versetzen, elf Funktionen auszuführen.

4. Rekonfigurierbare Zelle nach einem der vorhergehenden Ansprüche, **dadurch gekennzeichnet, daß** die Steuersignale (C1, C2, ...) eine Spannung aufweisen, die aus -Vdd, 0, +Vdd ausgewählt ist, wobei Vdd die Versorgungsspannung der Zelle ist.

5. Rekonfigurierbare Zelle nach einem der Ansprüche 1 bis 4, **dadurch gekennzeichnet, daß** sie in dynamischer Logik implementiert ist, wobei die Zweige der Zelle zwischen der Masse und einer Versorgungsklemme in Reihe geschaltet sind, zwischen einem Vorladetransistor vom Typ P (Mp) und einem Auswertetransistor vom Typ N (Mn), deren Gates von einem Taktsignal gesteuert werden, und **dadurch**, daß die Transistoren (M3, M4 und M5) der n-1 zu dem ersten Zweig parallelen Zweige asymmetrisch sind.

6. Rekonfigurierbare Zelle nach Anspruch 5, **dadurch gekennzeichnet, daß** alle Transistoren asymmetrisch sind.

7. Rekonfigurierbare Zelle nach einem der Ansprüche 1 bis 5, **dadurch gekennzeichnet, daß** sie in statischer Logik implementiert ist, wobei die Zweige der Zelle zwischen der Masse und einer Versorgungsklemme (Vdd) mit einem komplementären Netzwerk von Transistoren in Reihe geschaltet sind, das zwischen dem von der Masse am weitesten entfernten gemeinsamen Punkt der Zweige der Zelle, der den Ausgang (F) der Zelle darstellt, und der Versorgungsklemme (Vdd) angeordnet ist.

8. Rekonfigurierbare Zelle nach den Ansprüchen 2 bis 7, **dadurch gekennzeichnet, daß**, wenn n gleich 2 ist, das komplementäre Netzwerk zwischen der Versorgungsklemme und dem Ausgang (F) der Zelle einen MOSFET-Transistor (Q6) vom Typ P in Reihe mit zwei MOSFET-Transistoren (Q4, Q5) vom Typ P, die zueinander parallelgeschaltet und alle beide mit dem Ausgang (F) der Zelle verbunden sind, umfaßt, wobei der erste Eingang (A) mit den verbundenen Gates eines ersten parallelgeschalteten Transistors (Q5) vom Typ P verbunden ist, wobei der zweite Eingang (B) mit dem vorderen Gate des zweiten parallelgeschalteten Transistors (Q4) vom Typ P, dessen Gates getrennt sind, und mit dem vorderen Gate des in Reihe geschalteten Transistors (Q6) vom Typ P, dessen Gates ebenfalls getrennt sind, verbunden ist, wobei zwei Steuersignale (C3, C4), die an die hinteren Gates des parallelgeschalteten zweiten Transistors (Q4) vom Typ P und des in Reihe geschalteten Transistors (Q6) vom Typ P angelegt werden, ermöglichen, die rekonfigurierbare Zelle in die Lage zu versetzen, vier Funktionen auszuführen.

9. Rekonfigurierbare Zelle nach Anspruch 8, **dadurch gekennzeichnet, daß**, wenn die Transistoren alle symmetrisch sind, das Verhältnis W/L des parallelgeschalteten Transistors (Q4) vom Typ P mit getrennten Gates so eingestellt ist, daß es das Sperren dieses Transistors ermöglicht, wenn eine Spannung Vdd an das hintere Gate angelegt wird.

10. Rekonfigurierbare Zelle nach Anspruch 8, **dadurch gekennzeichnet, daß** der parallelgeschaltete Transistors (Q4) vom Typ P mit getrennten Gates asymmetrisch ist.

11. Rekonfigurierbare Zelle nach Anspruch 10, **dadurch gekennzeichnet, daß** alle Transistoren asymmetrisch sind.

12. Rekonfigurierbare Zelle nach einem der vorhergehenden Ansprüche 5, 6, 10 und 11, **dadurch gekennzeichnet, daß** die Asymmetrie der Transistoren so beschaffen ist, daß sie die Erhöhung der Schwellenspannung des vorderen Gates, das von dem Eingangslogiksignal gesteuert wird, bezüglich derjenigen des hinteren Gates, das von dem Steuersignal der logischen Funktion der Zelle gesteuert wird, ermöglicht.

13. Rekonfigurierbare Zelle nach einem der vorhergehenden Ansprüche 5, 6, 10,11 und 12, **dadurch gekennzeichnet, daß** die Asymmetrie eines Transistors (der Transistoren) auf eine solche Weise gewählt ist, daß ein Kompromiß zwischen der Stabilität der Betriebsarten des Transistors (der Transistoren) und den von der Zelle ausgeführten Funktionen mit Polarisationsspannungen unterhalb der Durchbruchgrenze des Gates des Transistors (der Transistoren) gewährleistet ist.

14. Rekonfigurierbare Zelle nach einem der vorhergehenden Ansprüche, **dadurch gekennzeichnet, daß** die asymmetrischen Gates unterschiedliche Gateoxiddicken aufweisen.

15. Rekonfigurierbare Zelle nach einem der vorhergehenden Ansprüche, **dadurch gekennzeichnet, daß** die asymmetrischen Gates so beschaffen sind, daß sie asymmetrische Arbeitsfunktionen aufweisen.
